# EUROPÄISCHE PATENTSCHRIFT

(11) **EP 1 008 993 B1**
(45) Veröffentlichungstag und Bekanntmachung des Hinweises auf die Patenterteilung: **18.07.2007**
(21) Anmeldenummer: 99121604.5
(22) Anmeldetag: 29.10.1999
(51) Int. Cl.: G11C 29/00

(54) **Schreib/Lesespeicher mit Selbsttestvorrichtung und zugehöriges Testverfahren**
Writeable memory with self-test device and method therefor
Mémoire avec dispositif de auto-test et sa mèthode

(30) Priorität: 30.10.1998 DE 19850115
(43) Veröffentlichungstag der Anmeldung: 14.06.2000
(73) Patentinhaber: Infineon Technologies AG, 81669 München (DE)
(72) Erfinder: Lammers, Stefan, 81739 München (DE); Weber, Werner, 80637 München (DE)
(74) Vertreter: Kottmann, Heinz Dieter

(56) Entgegenhaltungen:
- US-A- 4 493 075
- US-A- 5 278 839
- US-A- 5 764 878

## Beschreibung

Die Erfindung betrifft Vorrichtungen und Verfahren zum Testen von Schreib-/Lesespeichern mit integrierter Redundanz, bei denen Testmuster in einem Speicherfeld eingeschrieben und anschließend ausgelesen und verglichen werden sowie, wenn möglich, solange Wortleitungen und Spaltenauswahlleitungen durch redundante Leitungen ersetzt werden, bis keine Fehler mehr vorhanden sind.

Bisher prüften auf dem Speicherchip integrierte Selbsttestarchitekturen nur, die Fehlerfreiheit des zugehörigen Chips. Eine Redundanzanalyse, bei der aus den Fehleradressen die zu ersetzenden Leitungen ermittelt werden, erfolgte hingegen bisher mit Hilfe eines externen Rechners, da bislang zunächst alle defekten Speicherzellen bestimmt und erst danach eine entsprechende Ersetzungsstrategie ermittelt wurde. Da ein derartiges Testverfahren unter anderem einen sehr großen Fehlerspeicher benötigt, ist dieses Verfahren nur mit einem externen Rechner sinnvoll durchführbar und kann praktisch nicht als eingebauter Selbsttest durchgeführt werden.

Einen Schreib-/Lesespeicher der bereits einen Selbsttest inklusive Selbstreparatur durchführt ist aus dem Patent US 5278839 bekannt. Hierbei erfolgt neben der Selbstreparatur eine Überprüfung daraufhin, ob der Speicher bereits den Zustand der Nicht-Mehr-Selbstreparierbarkeit erreicht hat.

Die der Erfindung zugrundeliegende Aufgabe besteht nun darin, einen Schreib-/Lesespeicher mit einer integrierten Selbsttestvorrichtung und ein zugehöriges Testverfahren anzugeben, bei dem ein vollständiger Selbsttest inklusive einer weiterführenden Redundanzanalyse ohne wesentliche externe Unterstützung durchführbar ist entsprechend der zugehörigen Ansprüche.

Die Erfindung wird nachfolgend anhand von in den Zeichnungen dargestellten Ausführungsbeispielen näher erläutert. Dabei zeigt
- Figur 1: ein Blockdiagramm zur Erläuterung eines ersten Ausführungsbeispiels,
- Figur 2: ein Blockdiagramm zur Erläuterung eines zweiten Ausführungsbeispiels und
- Figur 3: ein Blockdiagramm zur Erläuterung eines dritten Ausführungsbeispiels.

Die Erfindung besteht im wesentlichen darin, daß ein Schreib-/Lesespeicher mit einer auf dem Chip befindlichen Selbsttestvorrichtung ohne wesentliche externe Testeinrichtungen dadurch getestet werden kann, daß nicht zunächst alle Fehler ermittelt werden und dann erst eine Redundanzanalyse erfolgt, sondern daß zu reparierende Leitungen gespeichert und von weiteren Untersuchungen ausgeschlossen werden und immer die Leitungen mit den meisten noch nicht erfaßten fehlerhaften Speicherzellen solange durch Redundanzleitungen virtuell ersetzt werden, bis entweder keine redundanten Leitungen oder keine fehlerhaften Zellen mehr vorhanden sind.

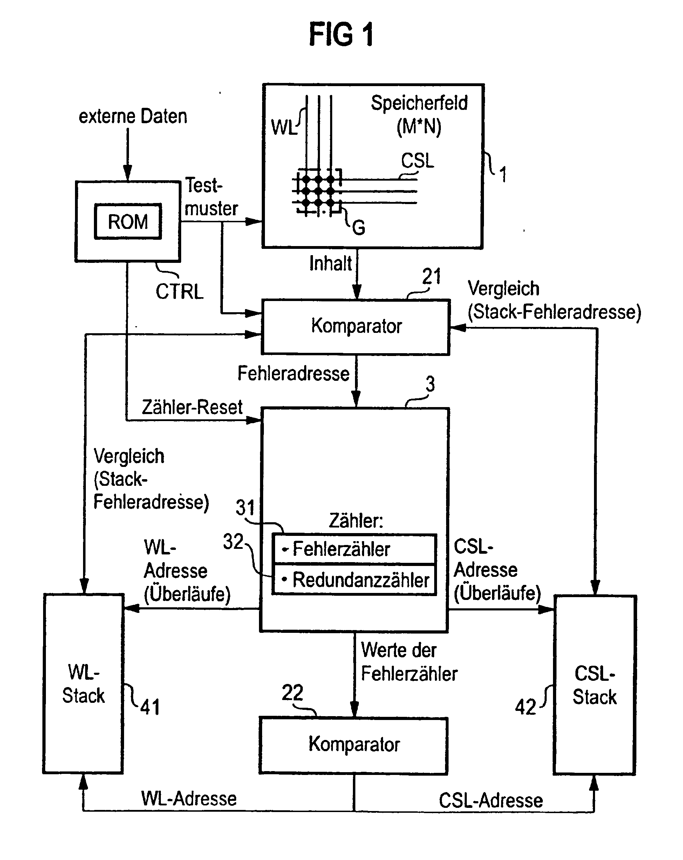

Figur 1 zeigt eine schematische Darstellung einer im Speicherchip integrierten Selbsttestarchitektur zur Reparatur eines Speicherbausteins unter Einsatz der vorhandenen Leitungsredundanz. Das Verfahren, das durch die Architektur realisiert wird ist iterativ, das heißt, es benötigt zur Ermittlung der zu aktivierenden Redundanzleitungen mehrere Testdurchläufe. Ein Testdurchlauf beinhaltet alle Testmuster, die für den entsprechenden Speicherchip während des sogenannten Prefuse-Tests vorgesehen sind. Von einer Steuereinheit CTRL die beispielsweise einen Nurlesespeicher ROM enthält, sind Testmuster in ein Speicherfeld einlesbar. Das Speicherfeld 1 entspricht hier einer Region eines Gesamtspeicherfeldes, dem eine gewisse Anzahl von redundanten Leitungen zugeordnet sind. Die Steuereinheit CTRL übernimmt die gesamte Ablaufsteuerung und kann mit externen Daten versorgt werden. Das Speicherfeld 1 weist eine Mehrzahl von Wortleitungen WL und eine Mehrzahl von Spaltenauswahlleitungen CSL auf und der Inhalt des Speicherfeldes wird durch einen Vergleicher 21 mit den eingeschriebenen Testmustern verglichen. Ferner führt der Vergleicher 21 einen Vergleich der Fehleradresse in Form von Wortleitung und Spaltenauswahlleitung mit in entsprechenden Stapelspeichern 41 und 42 gespeicherten Fehleradressen durch. Die im Vergleicher 21 festgestellte Fehleradresse steht Fehlerzählern 31 zur Verfügung. Darüber hinaus sind in der Selbsttestvorrichtung Redundanzzähler 32 vorgesehen. Werte der Fehlerzähler können in einem Vergleicher 22 verglichen werden.

In diesem Ausführungsbeispiel besitzt jede Wortleitung WL und jede Spaltenauswahlleitung einen eigenen Fehlerzähler. Zu Beginn des Testablaufs werden alle Fehlerzähler auf Null gesetzt. Während des ersten Testdurchlaufs werden die Wort- und Spaltenauswahlleitungen ermittelt, die eine besonders große Fehleranzahl aufweisen. Es wird für die Wortleitungen und die Spaltenauswahlleitungen eine Fehlerzahl bzw. eine Reparaturschwelle festgelegt, bei der die jeweilige Leitung durch eine entsprechend redundante Leitung ersetzt werden soll. Der Wert dieser Zahl ist vom zu testenden Speicherbaustein abhängig, da verschiedene Chips unterschiedliche Redundanzorganisationen besitzen können. Eine optimale Wahl dieser Reparaturschwelle kann für den jeweiligen zu testenden Chip in einfacher Weise experimentell ermittelt werden. Dabei muß auch der Flächenbedarf der Architektur berücksichtigt werden. Die Reparaturschwelle für die Wortleitungen kann von der der Spaltenauswahlleitungen verschieden sein.

Die Fehlerzähler werden z. B. vorteilhafterweise so dimensioniert, daß gerade im Falle des Überlaufs die Grenze erreicht wird, bei der eine Leitung durch eine entsprechende redundante Leitung ersetzt werden soll. Auf diese Weise kann sehr einfach das Überschreiten der verbliebenen Schwelle aufgrund eines Überlaufbits erfolgen.

Bevor die jeweiligen Fehlerzähler einer defekten Leitung erhöht werden, muß überprüft werden, ob die Wortleitungs- oder Spaltenauswahlleitungsadresse des Fehlers schon im zugehörigen Stapelspeicher abgelegt ist. In diesem Fall werden die Zähler nicht aktiviert, da der Fehler schon repariert wird. Dieser Vergleich muß schon im ersten Testdurchlauf erfolgen, weil ein Durchlauf aus mehreren Testmustern besteht. Dadurch wird vermieden, daß ein Fehler durch mehrere redundante Leitungen behoben wird. Die Adressen der Leitungen, deren Fehlerzähler nach dem ersten Testdurchlauf übergelaufen sind werden im Wortleitungsstapelspeicher 41 bzw. im Spaltenauswahlleitungsstapelspeicher 42 abgespeichert. Außerdem werden die zugehörigen Redundanzzähler 32 erhöht. Dazu muß die Domäne der zu ersetzenden Leitung bestimmt werden, denn es gibt üblicherweise für jede Wortleitungs- und für jede Spaltenauswahlleitungsdomäne eines Speicherchips eine fest vorgegebene Zahl an Redundanzleitungen. Das Speicherfeld 1 stellt eine Speicherregion dar, die wiederum aus WL- und CSL-Domänen besteht. Die Redundanzzähler sind vorteilhafterweise so ausgelegt, daß im Falle eines Überlaufs keine passende Redundanzleitung mehr vorhanden ist. Der Speicherbaustein ist also nicht reparierbar und der Test kann in diesem Fall sofort beendet werden.

Nachdem alle Testmuster einmal in den Schreib-/Lesespeicher eingeschrieben wurden, beginnt der zweite Teil des Verfahrens. Wiederholt werden die Testmuster an den Schreib-/Lesespeicher angelegt. Bei jedem Testdurchlauf werden alle Fehlerzähler auf Null gesetzt. Nun wird wiederum die Wortleitungs- und Spaltenauswahlleitungsadresse eines Fehlers mit den Einträgen der entsprechenden Stapelspeicher verglichen. Nur wenn keine der beiden Adressen in dem Stapelspeicher 41 und 42 abgelegt ist, werden die entsprechenden Fehlerzähler 31 erhöht. Nach einem Durchlauf wird mit Hilfe des Vergleichers 22 entschieden, welche Adresse, Wortleitung oder Spaltenauswahlleitung, im Stapelspeicher abgelegt wird. Dazu wird zunächst die Wortleitung und die Spaltenauswahlleitung mit der größten Fehleranzahl ermittelt. Dabei werden die Werte aller Fehlerzähler der Wortleitungen WL und die Fehlerzähler der Spaltenauswahlleitungen separat miteinander verglichen, wobei die Adresse der Wortleitung und der Spaltenauswahlleitung mit den meisten Fehlern ermittelt wird. Anschließend werden diese beiden Werte miteinander verglichen. Aus dem Vergleich geht hervor, welche der beiden Leitungen, also entweder die Wortleitung oder die Spaltenauswahlleitung, repariert werden soll. Existiert noch eine entsprechende Redundanzleitung in der betreffenden Domäne, ist also der Redundanzzähler dieser Domäne noch nicht übergelaufen, so wird die Adresse im Stapelspeicher abgelegt und der Redundanzzähler erhöht. Ansonsten wird die Adresse des anderen Maximums im Stapelspeicher gespeichert. Nur wenn auch für diese Leitung keine Redundanz mehr vorhanden ist, handelt es sich um einen irreparablen Speicherchip und der eingebaute Selbsttest kann abgebrochen werden. Beendet ist der Test, wenn der Speicherchip entweder keine Fehler mehr besitzt, daß heißt, daß alle Fehlerzähler nach einem Testdurchlauf auf Null sind, oder wenn keine passenden Redundanzleitungen vorhanden sind, also ein Redundanzzähler überläuft. Die Adressen der Leitungen, die ersetzt werden sollen, befinden sich nach einem vollständigen Testablauf in den Stapelspeichern 41 und 42. Dies sind sogenannte Fuse-Informationen, die der Laser benötigt, um den Chip mit der vorhandenen Redundanz reparieren zu können.

Um den Flächenbedarf dieser eingebauten Selbsttestarchitektur zu verringern, kann in einer vorteilhaften Ausgestaltung die Anzahl der Fehlerzähler reduziert werden. Das Verfahren wird hierbei nur unwesentlich verändert. Aus der Verringerung der Zähleranzahl resultiert eine höhere Testzeit, da eine größere Anzahl an Testdurchläufen notwendig ist. Denn wenn für jede Wortleitung und für jede Spaltenauswahlleitung ein Zähler vorhanden ist, kann mit dem oben beschriebenen Reparaturverfahren nach einem Testdurchlauf eine zu reparierende Leitung bestimmt werden. Stehen weniger Zähler zur Verfügung, so steigt die Anzahl der erforderlichen Testdurchläufe. Über einen Schalter kann den Fehlerzähler jeweils eine andere Gruppe G von Wortleitungen und Spaltenauswahlleitungen zugeordnet werden. Nach jedem Testdurchlauf wird dann die Wortleitung und die Spaltenauswahlleitungsadresse mit den bis dahin meisten Fehlern, sowie die zugehörigen Zählerwerte in einem weiteren Stapelspeicher abgespeichert. Dazu müssen alle neuen Zählerwerte mit dem bisherigen Maximalwert, welcher in einem Stapelspeicher abgelegt ist, verglichen werden. Dies erfolgt sowohl für die Wortleitungen als auch für die Spaltenauswahlleitungen. Danach werden die Zähler der nächsten Gruppe von Leitungen zugeordnet und es werden die Fehler auf diesen Leitungen gezählt.

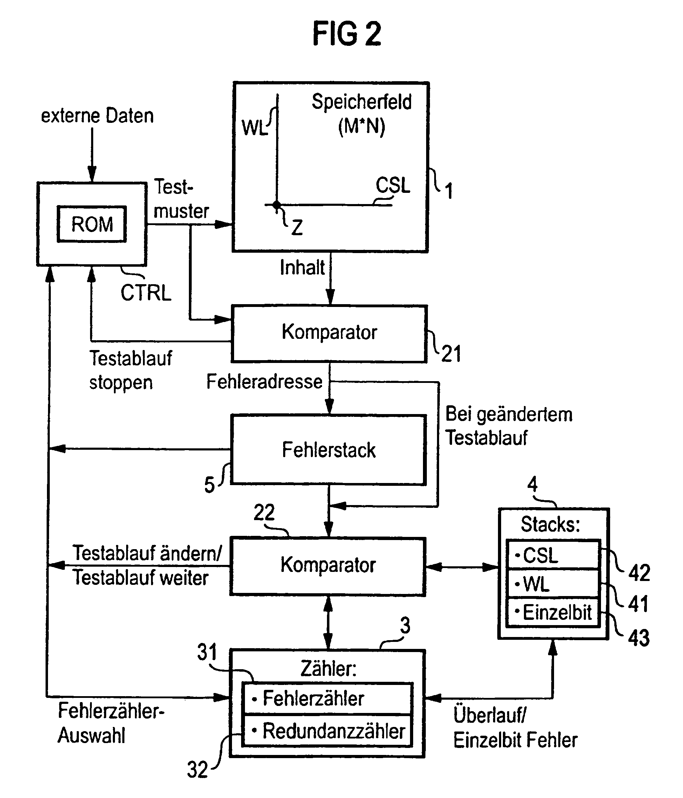

In Figur 2 ist ein zweites Ausführungsbeispiel der Erfindung näher erläutert, wobei sich die Darstellungen im wesentlichen dadurch unterscheiden, daß zusätzlich ein Fehlerstapelspeicher 5 und ein Einzelbitstapelspeicher 43 vorhanden sind. Darüber hinaus ist angedeutet, daß der Testablauf unterbrochen werden muß und ein veränderter Testablauf erfolgen muß, wenn eine fehlerhafte Speicherzelle entdeckt wird.

Auch bei diesem Verfahren sind zur Auswahl der zu reparierenden Leitungen mehrere Testdurchläufe erforderlich. Dieses Verfahren unterscheidet sich von dem ersten Ausführungsbeispiel dadurch, daß der Testablauf bei diesem Konzept unterbrochen werden muß, wenn ein Fehler erkannt wird. Die Fehleradresse, also die entsprechende Wortleitungs- und Spaltenauswahlleitungsadresse, wird dann im Fehlerstapelspeicher abgespeichert. Der Vergleicher 22 überprüft anschließend, ob die Fehleradresse in einem der Stapelspeicher 41 ... 43 gespeichert ist, wobei im Speicher 43 Einzelbitfehler gespeichert werden. Ist dies der Fall, so wird der Testablauf mit einer anderen Zelle fortgesetzt. Ansonsten folgt ein veränderter Testablauf. Es wird hierbei separat die Anzahl aller Fehler auf der Wortleitung WL und auf der Spaltenauswahlleitung CSL des ursprünglichen Fehlers ermittelt. Vor dem Zählen der Fehler muß überprüft werden, ob die zusätzlichen Fehler nicht schon durch das Aktivieren einer redundanten Leitung behoben werden. Zuvor müssen die Fehlerzähler auf Null gesetzt werden. Da beim ersten Vergleich festgestellt wurde, daß sowohl die Adresse der Wortleitung als auch die Adresse der Spaltenauswahlleitung des ursprünglichen Fehlers noch nicht in einem Stapelspeicher abgelegt ist, kann der folgende Vergleichsvorgang vereinfacht werden. Im Falle eines weiteren Fehlers auf der Wortleitung des ursprünglichen Fehlers muß lediglich der Stapelspeicher für die Spaltenauswahlleitungsadressen untersucht werden. Tritt ein zusätzlicher Fehler auf der Spaltenauswahlleitung des ursprünglichen Fehlers auf, so muß nur der Stapelspeicher die Wortleitungsadressen mit der Wortleitung des zusätzlichen Fehlers verglichen werden. Übersteigt die Fehleranzahl eine bestimmte Grenze, so wird die Adresse der Leitung im entsprechenden Stapelspeicher abgelegt und der zugehörige Redundanzzähler erhöht. Die Grenze, bei der repariert werden soll, wird in jedem folgenden Testdurchlauf herabgesetzt.

Dies kann vorteilhafterweise dadurch geschehen, daß die unterschiedlichen Grenzen durch Zähler mit unterschiedlicher Wortbreite festgelegt werden. Beim Überlauf der jeweiligen Zähler wird diese Grenze erreicht. So können beispielsweise im ersten Testdurchlauf zwei Drei-Bit-Zähler verwendet werden. Dadurch würden dann in diesem Durchgang die Adressen der Leitungen abgespeichert, die mehr als sieben Fehler aufweisen. Im nächsten Testdurchlauf könnten zwei Zwei-Bit-Zähler zum Einsatz kommen, so daß die Grenze für eine erforderliche Reparatur von acht auf vier herabgesetzt wird. Im folgenden Testdurchgang können zwei Ein-Bit-Zähler benutzt werden. Die Aktivierung der verschiedenen Zähler erfolgt über Befehle, die beispielsweise im Speicher ROM der Steuereinheit gespeichert sind. Die Anzahl und die Dimensionierung der Zähler richtet sich nach dem zu testenden Speicherchip.

Durch die Anzahl der verwendeten Fehlerzähler wird auch die Zahl der erforderlichen Testdurchläufe vorgegeben. Gibt es keine weiteren Fehler auf der Wortleitung WL und der Spaltenauswahlleitung CSL des ursprünglichen Fehlers, so handelt es sich um einen Einzelbitfehler, dessen Adresse im Stapelspeicher 43 gespeichert wird. In ihm wird die komplette Adresse, also die Wortleitungs- und die Spaltenauswahlleitungsadresse abgespeichert. Am Ende des eingebauten Selbsttests wird dieser Stapelspeicher bearbeitet. Die Fehler, die dort gespeichert sind, können sowohl durch eine redundante Wortleitung als auch durch eine redundante Spaltenauswahlleitung ersetzt werden. Da die redundanten Wortleitungen meist anders organisiert sind als die redundanten Spaltenauswahlleitungen, unterscheiden sich die Testergebnisse, je nachdem mit welchen Redundanzleitungen die Einzelbitfehler behoben werden. Beendet ist der komplette Testablauf, wenn keine benötigten Redundanzleitungen mehr vorhanden sind, oder alle Fehler behoben sind. Läuft einer der Redundanzzähler über, so ist der Speicherchip nicht reparierbar und der Test kann sofort abgebrochen werden. Die vollständige Reparatur des Chips wird dadurch erkannt, daß während eines gesamten Testdurchgangs die Zähler immer auf Null stehenbleiben. Sobald ein Fehlerzähler erhöht wird, so besitzt der Chip noch mindestens einen Fehler und der Testablauf kann in diesem Fall nicht beendet werden.

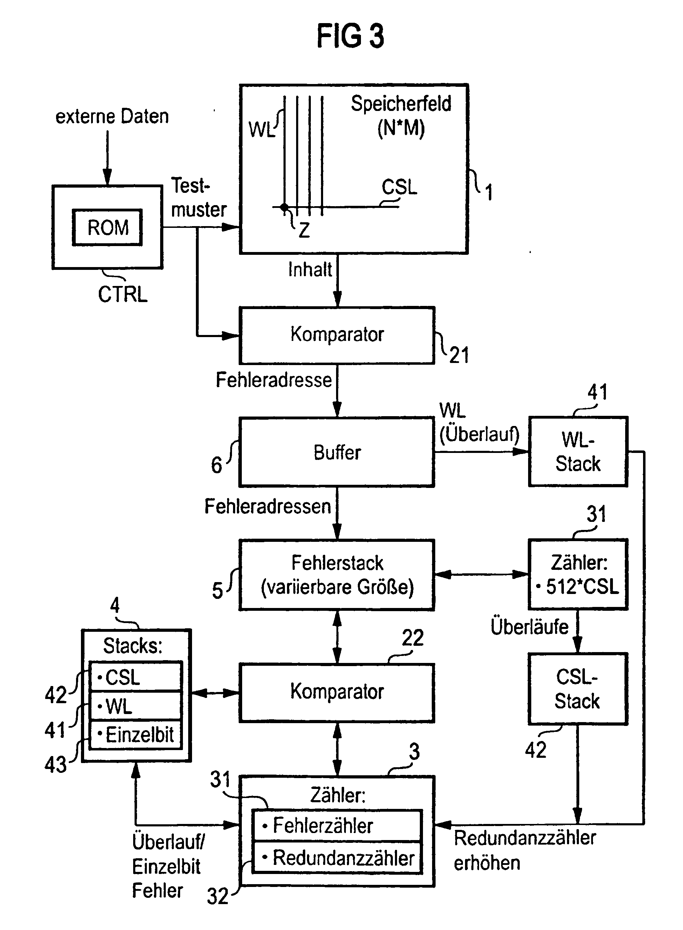

In Figur 3 ist ein Blockdiagramm zur Erläuterung eines dritten Ausführungsbeispiels der Erfindung dargestellt, das sich im wesentlichen durch einen zusätzlichen Pufferspeicher 6 vom Blockdiagramm in Figur 2 unterscheidet. Der große Vorteil dieses Konzeptes besteht darin, daß nur ein einziger Testdurchlauf zur Bestimmung der zu ersetzenden Wortleitungen und Spaltenauswahlleitungen benötigt wird. Außerdem muß der Testablauf nicht abgeändert werden, was gewisse Nachteile mit sich bringen würde. Die Fehleradressen der jeweiligen Wortleitung werden in einem Pufferspeicher abgespeichert. Wird eine bestimmte Fehleranzahl auf dieser Wortleitung überschritten, so wird die Wortleitungsadresse im Stapelspeicher 41 abgelegt und der Inhalt des Pufferspeichers gelöscht. Außerdem muß der entsprechende Redundanzzähler 32 erhöht werden. Besitzt die Wortleitung weniger Fehler als die festgelegte Fehleranzahl, so wird der komplette Inhalt des Pufferspeichers, also alle gespeicherten Wortleitungs- und Spaltenauswahlleitungsadressen in den Fehlerstapelspeicher 5 eingeschrieben und anschließend der Pufferspeicher gelöscht. Die Größe des Fehlerstapelspeichers 5 beeinflußt die Testergebnisse. Während die nächste Wortleitung getestet wird, das heißt, die Fehleradressen bestimmt und in dem Pufferspeicher abgespeichert werden, erfolgt die Bearbeitung des Fehlerstapelspeichers. Es werden die Spaltenauswahlleitungen ermittelt und im Stapelspeicher 42 abgespeichert, die eine gewisse Fehleranzahl übertreffen. Dazu werden die entsprechenden CSL-Fehlerzähler 31 erhöht. Es gibt bei dieser Architektur für jede Spaltenauswahlleitung der zu testenden Speicherregion einen Fehlerzähler. Die Fehlerzähler für die jeweiligen Spaltenauswahlleitungen werden immer dann aktiviert, wenn neue Fehleradressen vom Pufferspeicher in den Fehlerspeicher eingeschrieben werden. Läuft einer dieser Fehlerzähler über, so wird die entsprechende Spaltenauswahlleitungsadresse im Stapelspeicher 42 abgespeichert. Außerdem müssen die zugehörigen Einträge, also die Spaltenauswahlleitungsadresse und die Wortleitungsadresse, aus dem Fehlerstapelspeicher gelöscht werden, da die Fehler nun durch den Einsatz einer redundanten Spaltenauswahlleitung repariert werden. Zudem wird der zugehörige Redundanzzähler erhöht. Diese Vorgehensweise sorgt dafür, daß auch bei Integration eines relativ kleinen Fehlerstapelspeichers schon akzeptable Testergebnisse erzielt werden. Läuft der Fehlerstapelspeicher über, so ist eine Reparatur des Chips mit Hilfe dieses Verfahrens nicht möglich und der eingebaute Selbsttest kann an dieser Stelle sofort abgebrochen werden. Nachdem der Testablauf beendet ist, muß der Inhalt des Fehlerstapelspeichers ausgewertet werden. Zur Auswertung des Fehlerstapelspeichers kann beispielsweise das im zweiten Ausführungsbeispiel erläuterte Verfahren verwendet werden.

Programmlistings als Anlage

## Patentansprüche

1. Schreib-/Lesespeicher mit mindestens einem Speicherfeld (1) und einer Selbsttestvorrichtung,
- bei dem die Selbsttestvorrichtung zusammen mit dem mindestens einem Speicherfeld monolithisch integriert ist und Fehlerzähler (31) für Wortleitungen (WL) und Spaltenauswahlleitungen (CSL), Redundanzverbrauchszähler (32), Stapelspeicher (41, 42) für zu reparierende Wortleitungen und Spaltenauswahlleitungen, Vergleicher (21, 22) und eine Steuereinheit (CTRL) aufweist,
- bei dem Vergleicher mit den Stapelspeichern für zu reparierende Wortleitungen und Spaltenauswahlleitungen und Vergleicher mit Fehlerzählern für Wortleitungen (WL) und Spaltenauswahlleitungen (CSL) verbunden sind und
- bei dem die Steuereinheit (CTRL) derart ausgebildet ist, dass der Reihe nach
a) zunächst alle Fehlerzähler und Redundanzverbrauchszähler auf Null gesetzt werden,
b) mit Hilfe der Vergleicher ein Vergleich zwischen einer in das Speicherfeld eingeschriebenen und aus diesem ausgelesenen Information erfolgt und eine fehlerhafte Zelle festgestellt wird,
c) die zur fehlerhaften Zelle gehörige Wortleitung und Spaltenauswahlleitung überprüft wird, ob sie im Stapelspeicher bereits gespeichert ist und nur dann der zur jeweiligen Wortleitung und jeweiligen Spaltenauswahlleitung gehörige Zähler erhöht wird, wenn die Wortleitung oder die Spaltenauswahlleitung noch nicht gespeichert wurde,
d) die Wortleitung und/oder die Spaltenauswahlleitung im Stapelspeicher abgespeichert und der zugehörige Redundanzverbrauchszähler erhöht werden, wenn die zugehörigen Fehlerzähler eine Reparaturschwelle überschreiten,
e) die Schritte b) bis d) für alle vorgegebenen Testmuster und alle Zellen des Speicherfeldes erfolgen oder bis einer der Redundanzverbrauchszähler überläuft,
f) alle Fehlerzähler auf Null gesetzt werden,
g) der Schritt b) durchgeführt wird,
h) der Schritt c) erfolgt,
i) mit Hilfe der Vergleicher und der Fehlerzähler getrennt die Wortleitung und die Spaltenauswahlleitung mit der größten Fehlerzahl ermittelt wird,
j) entweder die Wortleitung oder die Spaltenauswahlleitung mit der größten Fehlerzahl ausgewählt wird,
k) diese im Stapelspeicher gespeichert und der zugehörige Redundanzverbrauchszähler inkrementiert wird, falls der zugehörige Redundanzverbrauchszähler noch nicht übergelaufen ist,
l) mit der anderen der nach Schritt i) ausgewählten Leitung Schritt k) durchgeführt wird, wenn für die nach Schritt j) ausgewählte Leitung der zugehörige Redundanzverbrauchszähler übergelaufen ist,
m) der Test abgebrochen wird, wenn der Redundanzverbrauchszähler überläuft,
n) die Schritte f) bis m) für alle vorgegebenen Testmuster und für alle Speicherzellen des Speicherfeldes wiederholt werden und
o) Schritt n) solange wiederholt wird, bis alle Fehlerzähler gleich Null bleiben oder einer der Redundanzverbrauchszähler überläuft.

2. Schreib-/Lesespeicher nach Anspruch 1,
bei dem weniger Fehlerzähler als Wortleitungen und Spaltenauswahlleitungen und ein zusätzlicher Speicher für ein Maximum und eine zugehörige Fehlerzahl vorhanden sind und die Fehlerzähler über Schalter verschiedenen Gruppen (G) von Wortleitungen und Spaltenauswahlleitungen zuordenbar sind und bei dem die Steuereinheit derart vorhanden ist, dass mit Hilfe der Vergleicher die Wortleitungen und Spaltenauswahlleitungen mit der größten Fehlerzahl innerhalb einer Gruppe ermittelt und im Stapelspeicher anstelle der Wortleitungen und Spaltenauswahlleitungen mit der bisher größten Fehlerzahl gespeichert werden, wenn die Fehlerzahl größer ist als die bisherige größte Fehlerzahl und dass anstelle aller Zellen nur die zur jeweiligen Gruppe von Wortleitungen und Spaltenauswahlleitungen gehörigen Zellen getestet werden und der Test für alle Gruppen des Speicherzellenfeldes wiederholt wird.

3. Schreib-/Lesespeicher nach Anspruch 1 oder 2,
bei der in Schritt j) diejenige der beiden Leitungen ausgewählt wird, die die größte Fehlerzahl aufweist.

4. Schreib-/Lesespeicher nach Anspruch 1,
bei dem zusätzlich ein Pufferspeicher (6) vorhanden ist und eine Steuereinheit (CTRL) derart vorhanden ist, dass zunächst, vor den Schritten a) bis g), der Reihe nach
A) die fehlerhaften Zellen einer Wortleitung (WL) mit Wortleitung (WL) und Spaltenauswahlleitung (CSL) im Pufferspeicher gespeichert werden,
B) geprüft wird, ob die Fehleranzahl innerhalb einer Wortleitung eine durch die Größe des Pufferspeichers vorgegebene Reparaturschwelle überschreitet und, wenn die Reparaturschwelle nicht überschritten wird, der Pufferinhalt in den Fehlerstapelspeicher übernommen und der Puffer gelöscht wird,
C) eine fehlerhafte Wortleitung in den Wortleitungsstapelspeicher übernommen wird, der Pufferspeicher gelöscht und der entsprechende Redundanzverbrauchszähler erhöht wird, wenn die Reparaturschwelle überschritten wurde, und
D) während die nächste Wortleitung durch die Schritte A) bis C) getestet wird, die im Fehlerstapelspeicher befindlichen Fehler der vorhergehenden Wortleitung bearbeitet werden, wobei der für die jeweilige Spaltenauswahlleitung vorgesehene Fehlerzähler (31) erhöht wird und im Falle eines Zählerüberlaufs betreffende Spaltenauswahlleitung im Stapelspeicher (42) für fehlerhafte Spaltenauswahlleitungen gespeichert und der entsprechende Redundanzverbrauchszähler (32) erhöht wird,
E) die Schritte A) bis D) für alle vorgegebenen Testmuster und alle Zellen des Speicherfeldes wiederholen oder abbrechen und bereits als nicht reparierbar melden, wenn der Fehlerstapelspeicher oder einer der Redundanzverbrauchszähler überläuft.

5. Schreib-/Lesespeicher mit mindestens einem Speicherfeld (1) und einer Selbsttestvorrichtung,
- bei dem die Selbsttestvorrichtung zusammen mit dem mindestens einem Speicherfeld monolithisch integriert ist und Fehlerzähler (31) für Wortleitungen (WL) und Spaltenauswahlleitungen (CSL), Redundanzverbrauchszähler (32), Stapelspeicher (41, 42) für zu reparierende Wortleitungen und Spaltenauswahlleitungen, Vergleicher (21, 22) und eine Steuereinheit (CTRL) aufweist,
- bei dem Vergleicher mit den Stapelspeichern für zu reparierende Wortleitungen und Spaltenauswahlleitungen und Vergleicher mit Fehlerzählern für Wortleitungen (WL) und Spaltenauswahlleitungen (CSL) verbunden sind und
- bei dem die Fehlerzähler (31) mit unterschiedlicher Wortbreite nur für eine Wortleitung (WL) und eine Spaltenauswahlleitung (CSL), zusätzlich ein Stapelspeicher (43) für Einzelbitfehler und ein Fehlerstapelspeicher (5) vorhanden sind und die Steuereinheit (CTRL) derart ausgebildet ist, dass der Reihe nach
a) zunächst alle Fehlerzähler und Redundanzverbrauchszähler gleich Null gesetzt werden,
b) mit Hilfe der Vergleicher ein Vergleich zwischen den in das Speicherfeld eingeschriebenen Informationen und ausgelesenen Informationen erfolgt und die fehlerhafte Zeile festgestellt und im Fehlerstapelspeicher gespeichert wird,
c) die zur fehlerhaften Zelle gehörige Wortleitung (WL) als auch die Spaltenauswahlleitung (CSL) mit Hilfe eines der Vergleicher überprüft wird, ob sie im Stapelspeicher, als fehlerhafte Wortleitung, fehlerhafte Spaltenauswahlleitung oder als Einzelbitfehler bereits gespeichert ist und die Schritte d) und e) übergangen werden, wenn die Wortleitung und/oder die Spaltenauswahlleitung oder der Einzelfehler bereits gespeichert sind,
d) zur fehlerhaften Speicherzelle (Z) gehörige im Fehlerstapelspeicher gespeicherte Wortleitungen und Spaltenauswahlleitungen separat auf weitere Fehler überprüft werden und der zur Wortleitung gehörige Fehlerzähler bzw. der zur Spaltenauswahlleitung gehörige Fehlerzähler nur dann erhöht werden, wenn der jeweilige weitere Fehler noch nicht in einem Stapelspeicher gespeichert ist,
e) Wortleitungen und/oder Spaltenauswahlleitungen im entsprechenden Stapelspeicher gespeichert sowie der zugehörige Redundanzverbrauchszähler erhöht werden wenn der zugehörige Fehlerzähler eine Reparaturschwelle überschreitet,
f) alle Fehlerzähler gleich Null gesetzt werden und die Schritte b) bis e) für alle Testmuster und alle Speicherzellen des Speicherfeldes wiederholen und
g) die Reparaturschwelle senken durch einen Fehlerzähler mit geringerer Wortbreite sowie den Schritt f) solange wiederholen, bis bei der niedrigsten Reparaturschwelle die Fehlerzähler für alle Testmuster und alle Speicherzellen gleich Null bleiben oder der Redundanzzähler überläuft.

6. Schreib-/Lesespeicher nach Anspruch 5,
bei dem im Schritt d) weitere Fehler in der Wortleitung (WL) nur im Stapelspeicher (42) für die zu reparierenden Auswahlleitungen und weitere Fehler in der zugehörigen Spaltenauswahlleitung (CSL) nur im Stapelspeicher (41) für die Wortleitungen gesucht werden.

7. Verfahren zum Testen eines Schreib-/Lesespeichers mit einer Selbsttestvorrichtung,
- bei dem zu reparierende Wortleitungen (WL) und/oder Spaltenauswahlleitungen (CSL) gespeichert und deren Zellen für weitere Untersuchungen ausgeschlossen werden,
- bei dem die Wortleitungen und/oder die Spaltenauswahlleitungen mit den meisten noch nicht bereits von den gespeicherten Wortleitungen und/oder Spaltenauswahlleitungen erfassten fehlerhaften Speicherzellen ermittelt und vor den anderen Wortleitungen und/oder die Spaltenauswahlleitungen untersucht werden,
- bei dem festgestellt wird, ob die Anzahl der redundanten Leitungen noch ausreicht und ob bereits keine fehlerhaften Zellen mehr vorhanden sind, und
- bei dem
a) zunächst Fehlerzähler und Redundanzverbrauchszähler auf Null gesetzt werden,
b) ein Vergleich zwischen einer in das Speicherfeld eingeschriebenen und aus diesem ausgelesenen Information erfolgt und eine fehlerhafte Zelle festgestellt wird,
c) die zur fehlerhaften Zelle gehörige Wortleitung und Spaltenauswahlleitung überprüft wird, ob sie bereits gespeichert ist und nur dann der zur jeweiligen Wortleitung oder jeweiligen Spaltenauswahlleitung gehörige Fehlerzähler erhöht wird, wenn die Wortleitung oder die Spaltenauswahlleitung noch nicht gespeichert wurde,
d) die Wortleitung und/oder die Spaltenauswahlleitung abgespeichert und der zugehörige Redundanzverbrauchszähler erhöht werden, wenn die zugehörigen Fehlerzähler eine Reparaturschwelle überschreiten,
e) die Schritte b) und d) für alle vorgegebenen Testmuster und alle Zellen des Speicherfeldes erfolgen oder bis die Redundanz verbraucht ist,
f) alle Fehlerzähler auf Null gesetzt werden,
g) der Schritt b) durchgeführt wird,
h) der Schritt c) erfolgt,
i) mit Hilfe der Vergleicher und der Fehlerzähler getrennt die Wortleitung und die Spaltenauswahlleitung mit der größten Fehlerzahl ermittelt wird,
j) entweder die Wortleitung oder die Spaltenauswahlleitung mit der größten Fehlerzahl ausgewählt wird,
k) diese gespeichert und der Redundanzverbrauchszähler inkrementiert wird, falls noch benötigte Redundanz vorhanden ist,
l) mit der anderen der nach Schritt i) ausgewählten Leitung Schritt k) durchgeführt wird, wenn für die nach Schritt j) ausgewählte Leitung keine Redundanz mehr vorhanden ist,
m) der Test abgebrochen wird, wenn die entsprechende Redundanz verbraucht ist,
n) die Schritte f) bis m) für alle vorgegebenen Testmuster und für alle Speicherzellen des Speicherfeldes wiederholt werden und Schritt n) solange wiederholt wird, bis keine Fehler mehr vorhanden sind oder die Redundanz aufgebraucht ist.

8. Verfahren zum Testen eines Schreib-/Lesespeichers mit einer Selbsttestvorrichtung,
- bei dem zu reparierende Wortleitungen (WL) und/oder Spaltenauswahlleitungen (CSL) gespeichert und deren Zellen für weitere Untersuchungen ausgeschlossen werden,
- bei dem die Wortleitungen und/oder die Spaltenauswahlleitungen mit den meisten noch nicht bereits von den gespeicherten Wortleitungen und/oder Spaltenauswahlleitungen erfassten fehlerhaften Speicherzellen ermittelt und vor den anderen Wortleitungen und/oder die Spaltenauswahlleitungen untersucht werden,
- bei dem festgestellt wird, ob die Anzahl der redundanten Leitungen noch ausreicht und ob bereits keine fehlerhaften Zellen mehr vorhanden sind, und
- bei dem
a) zunächst alle Fehlerzähler und alle Redündanzverbrauchszähler gleich Null gesetzt werden,
b) ein Vergleich zwischen den in das Speicherfeld eingeschriebenen Informationen und den ausgelesenen Informationen erfolgt und die fehlerhafte Zelle festgestellt und gespeichert wird,
c) die zur fehlerhaften Zelle gehörige Wortleitung (WL) als auch die Spaltenauswahlleitung (CSL) überprüft wird, ob sie als fehlerhafte Wortleitung, fehlerhafte Spaltenauswahlleitung oder als Einzelbitfehler bereits gespeichert ist und die Schritte d) und e) übergangen werden, wenn sie bereits gespeichert ist,
d) zur fehlerhaften Speicherzelle (Z) gehörige zwischengespeicherte Wortleitungen und Spaltenauswahlleitungen separat auf Fehler überprüft werden und der zur Wortleitung gehörige Fehlerzähler bzw. der zur Spaltenauswahlleitung gehörige Fehlerzähler nur dann erhöht werden, wenn der jeweilige Fehler noch nicht gespeichert ist,
e) Wortleitungen und/oder Spaltenauswahlleitungen gespeichert sowie der entsprechende Redundanzverbrauchszähler erhöht werden, wenn der zugehörige Fehlerzähler eine Reparaturschwelle überschreitet,
f) zunächst alle Fehlerzähler gleich Null gesetzt und die Schritte b) bis e) für alle Testmuster und alle Speicherzellen des Speicherfeldes wiederholen werden und
g) die Reparaturschwelle gesenkt sowie der Schritt f) solange wiederholt werden, bis, bei der niedrigsten Reparaturschwelle, für alle Testmuster und alle Speicherzellen keine Fehler mehr auftreten oder einer der Redundanzverbrauchszähler überläuft.

9. Verfahren zum Testen eines Schreib-/Lesespeichers nach Anspruch 8, bei dem zunächst vor den Schritten a) bis g) der Reihe nach
A) die fehlerhaften Zellen einer Wortleitung (WL) mit Wortleitung (WL) und Spaltenauswahlleitung (CSL) in einem Pufferspeicher gespeichert werden,
B) geprüft wird, ob die Fehleranzahl innerhalb einer Wortleitung eine Reparaturschwelle überschreitet und, wenn die Reparaturschwelle nicht überschritten wird, der Inhalt des Pufferspeichers in einen Fehlerstapelspeicher übernommen und der Fehlerspeicher gelöscht wird,
C) eine fehlerhafte Wortleitung gespeichert wird, der Puffer gelöscht und der entsprechende Redundanzverbrauchszähler erhöht wird, wenn die Reparaturschwelle überschritten wurde, und
D) während die nächste Wortleitung durch die Schritte A) und C) getestet wird, die im Fehlerstapelspeicher befindlichen Fehler der vorhergehenden Wortleitung bearbeitet werden, wobei der für die jeweilige Spaltenauswahlleitung vorgesehene Fehlerzähler (31) erhöht wird und beim Überschreiten einer Reparaturschwelle betreffende Spaltenauswahlleitung gespeichert und der entsprechende Redundanzverbrauchszähler (32) erhöht wird,
E) die Schritte A) bis D) für alle vorgegebenen Testmuster und alle Zellen des Speicherfeldes wiederholen oder abbrechen und bereits als nicht reparierbar melden, wenn der Fehlerstapelspeicher oder einer der Redundanzzähler überläuft.

## Claims

1. Read/write memory with at least one memory array (1) and a self-test device,
- in which the self-test device is monolithically integrated together with the at least one memory array and has defect counters (31) for word lines (WL) and column select lines (CSL), redundancy consumption counters (32), stack stores (41, 42) for word lines and column select lines to be repaired, comparators (21, 22) and a control unit (CTRL),
- in which comparators are connected to the stack stores for word lines and column select lines to be repaired and comparators are connected to defect counters for word lines (WL) and column select lines (CSL), and
- in which the control unit (CTRL) is designed in such a way that, in order,
a) firstly all the defect counters and redundancy consumption counters are set to zero,
b) with the aid of the comparators, a comparison is made between an information item written to the memory array and an information item read from said memory array and a defective cell is ascertained,
c) the word line and column select line associated with the defective cell is checked to see whether it is already stored in the stack store and the counter associated with the respective word line and respective column select line is incremented only when the word line or the column select line has not yet been stored,
d) the word line and/or the column select line are stored in the stack store and the associated redundancy consumption counter is incremented if the associated defect counters exceed a repair threshold,
e) steps b) to d) are carried out for all the prescribed test patterns and all the cells of the memory array or until one of the redundancy consumption counters overflows,
f) all the defect counters are set to zero,
g) step b) is carried out,
h) step c) is carried out,
i) with the aid of the comparators and the defect counters, the word line and the column select line with the largest number of defects are determined separately,
j) either the word line or the column select line with the largest number of defects is selected,
k) this is stored in the stack store and the associated redundancy consumption counter is incremented if the associated redundancy consumption counter has not yet overflowed,
l) step k) is carried out with the other of the lines selected according to step i) if, for the line selected according to step j), the associated redundancy consumption counter has overflowed,
m) the test is terminated if the redundancy consumption counter overflows,
n) steps f) to m) are repeated for all the prescribed test patterns and for all the memory cells of the memory array, and
o) step n) is repeated until all the defect counters remain equal to zero or one of the redundancy consumption counters overflows.

2. Read/write memory according to Claim 1,
in which fewer defect counters than word lines and column select lines and an additional store for a maximum and an associated number of defects are present and the defect counters can be assigned via switches to different groups (G) of word lines and column select lines, and in which the control unit is present in such a way that, with the aid of the comparators, the word lines and column select lines with the largest number of defects within a group are determined and stored in the stack store instead of the word lines and column select lines with the previously largest number of defects if the number of defects is greater than the previous largest number of defects, and that instead of all the cells, only the cells associated with the respective group of word lines and column select lines are tested and the test is repeated for all the groups in the memory cell array.

3. Read/write memory according to Claim 1 or 2, in which, in step j), that line of the two lines which has the largest number of defects is selected.

4. Read/write memory according to Claim 1,
in which, in addition, a buffer store (6) is present and a control unit (CTRL) is present in such a way that firstly, prior to steps a) to g), in order,
A) the defective cells of a word line (WL) are stored with word line (WL) and column select line (CSL) in the buffer store,
B) a check is made to see whether the number of defects within a word line exceeds a repair threshold prescribed by the size of the buffer store and, if the repair threshold is not exceeded, the buffer content is accepted in the defect stack store and the buffer is cleared,
C) a defective word line is accepted in the word line stack store, the buffer store is cleared and the corresponding redundancy consumption counter is incremented if the repair threshold has been exceeded, and
D) while the next word line is being tested by steps A) to C) the defects of the previous word line which are situated in the defect stack store are processed, the defect counter (31) provided for the respective column select line being incremented and, in the event of a counter overflow, the relevant column select line being stored in the stack store (42) for defective column select lines and the corresponding redundancy consumption counter (32) being incremented,
E) steps A) to D) are repeated for all the prescribed test patterns and all the cells of the memory array or are terminated and already reported to be non-repairable if the defect stack store or one of the redundancy consumption counters overflows.

5. Read/write memory with at least one memory array (1) and a self-test device,
- in which the self-test device is monolithically integrated together with the at least one memory array and has defect counters (31) for word lines (WL) and column select lines (CSL), redundancy consumption counters (32), stack stores (41, 42) for word lines and column select lines to be repaired, comparators (21, 22) and a control unit (CTRL),
- in which comparators are connected to the stack stores for word lines and column select lines to be repaired and comparators are connected to defect counters for word lines (WL) and column select lines (CSL), and
- in which the defect counters (31) are present with a different word width only for a word line (WL) and a column select line (CSL), in addition a stack store (43) for single-bit defects and a defect stack store (5) are present and the control unit (CTRL) is designed in such a way that, in order,
a) firstly all the defect counters and redundancy consumption counters are set to be equal to zero,
b) with the aid of the comparators, a comparison is made between the information items written to the memory array and information items read out and the defective cell is ascertained and stored in the defect stack store,
c) the word line (WL) associated with the defective cell, and also the column select line (CSL) is checked with the aid of one of the comparators to see whether it is already stored in the stack store, as defective word line, defective column select line or as single-bit defect, and steps d) and e) are skipped if the word line and/or the column select line or the individual defect are/is already stored,
d) word lines and column select lines associated with the defective memory cell (Z) and stored in the defect stack store are checked separately for further defects and the defect counter associated with the word line and/or the defect counter associated with the column select line are/is incremented only when the respective further defect has not yet been stored in a stack store,
e) word lines and/or column select lines are stored in the corresponding stack store and also the associated redundancy consumption counter is incremented if the associated defect counter exceeds a repair threshold,
f) all the defect counters are set to be equal to zero and steps b) to e) are repeated for all the test patterns and all the memory cells of the memory array, and
g) the repair threshold is decreased by a defect counter with a smaller word width and also step f) is repeated until, at the lowest repair threshold, the defect counters for all the test patterns and all the memory cells remain equal to zero or the redundancy counter overflows.

6. Read/write memory according to Claim 5,
in which, in step d), further defects in the word line (WL) are sought only in the stack store (42) for the select lines to be repaired and further defects in the associated column select line (CSL) are sought only in the stack store (41) for the word lines.

7. Method for testing a read/write memory with a self-test device,
- in which word lines (WL) and/or column select lines (CSL) to be repaired are stored and their cells are excluded for further examinations,
- in which the word lines and/or the column select lines having the most defective memory cells not yet already detected by the stored word lines and/or column select lines are determined and examined before the other word lines and/or the column select lines,
- in which it is ascertained whether the number of redundant lines still suffices and whether there are already no more defective cells present, and
- in which
a) firstly the defect counters and redundancy consumption counters are set to zero,
b) a comparison is made between an information item written to the memory array and an information item read from said memory array and a defective cell is ascertained,
c) the word line and column select line associated with the defective cell is checked to see whether it is already stored and the defect counter associated with the respective word line or respective column select line is incremented only when the word line or the column select line has not yet been stored,
d) the word line and/or the column select line are stored and the associated redundancy consumption counter is incremented if the associated defect counters exceed a repair threshold,
e) steps b) to d) are carried out for all the prescribed test patterns and all the cells of the memory array or until the redundancy has been consumed,
f) all the defect counters are set to zero,
g) step b) is carried out,
h) step c) is carried out,
i) with the aid of the comparators and the defect counters, the word line and the column select line with the largest number of defects are determined separately,
j) either the word line or the column select line with the largest number of defects is selected,
k) this is stored and the redundancy consumption counter is incremented if redundancy that is still required is present,
l) step k) is carried out with the other of the lines selected according to step i) if, for the line selected according to step j), there is no more redundancy present,
m) the test is terminated if the corresponding redundancy has been consumed,
n) steps f) to m) are repeated for all the prescribed test patterns and for all the memory cells of the memory array, and step n) is repeated until there are no more defects present or the redundancy has been used up.

8. Method for testing a read/write memory with a self-test device,
- in which word lines (WL) and/or column select lines (CSL) to be repaired are stored and their cells are excluded for further examinations,
- in which the word lines and/or the column select lines having the most defective memory cells not yet already detected by the stored word lines and/or column select lines are determined and examined before the other word lines and/or the column select lines,
- in which it is ascertained whether the number of redundant lines still suffices and whether there are already no more defective cells present, and,
- in which
a) firstly all the defect counters and all the redundancy consumption counters are set to be equal to zero,
b) a comparison is made between the information items written to the memory array and information items read out and the defective cell is ascertained and stored,
c) the word line (WL) associated with the defective cell, and also the column select line (CSL) is checked to see whether it is already stored as defective word line, defective column select line or as single-bit defect, and steps d) and e) are skipped if is already stored,
d) buffer-stored word lines and column select lines associated with the defective memory cell (Z) are checked separately for defects and the defect counter associated with the word line and/or the defect counter associated with the column select line are/is incremented only when the respective defect has not yet been stored,
e) word lines and/or column select lines are stored and also the corresponding redundancy consumption counter is incremented if the associated defect counter exceeds a repair threshold,
f) firstly all the defect counters are set to be equal to zero and steps b) to e) are repeated for all the test patterns and all the memory cells of the memory array, and
g) the repair threshold is decreased and also step f) is repeated until, at the lowest repair threshold, for all the test patterns and all the memory cells no more defects occur or one of the redundancy consumption counters overflows.

9. Method for testing a read/write memory according to Claim 8, in which firstly, prior to steps a) to g), in order,
A) the defective cells of a word line (WL) are stored with word line (WL) and column select line (CSL) in a buffer store,
B) a check is made to see whether the number of defects within a word line exceeds a repair threshold and, if the repair threshold is not exceeded, the content of the buffer store is accepted in a defect stack store and the buffer store is cleared,
C) a defective word line is stored, the buffer store is cleared and the corresponding redundancy consumption counter is incremented if the repair threshold has been exceeded, and
D) while the next word line is being tested by steps A) and C) the defects of the previous word line which are situated in the defect stack store are processed, the defect counter (31) provided for the respective column select line being incremented and, in the event of a repair threshold being exceeded, the relevant column select line being stored and the corresponding redundancy consumption counter (32) being incremented,
E) steps A) to D) are repeated for all the prescribed test patterns and all the cells of the memory array or are terminated and already reported to be non-repairable if the defect stack store or one of the redundancy consumption counters overflows.

## Revendications

1. Mémoire d'écriture/lecture comprenant au moins un champ (1) de mémoire et un dispositif d'auto-test,
- dans lequel le dispositif d'auto-test est intégré monolithiquement ensemble avec le au moins un champ de mémoire et a des compteurs (31) d'erreur pour des lignes (WL) de mot et pour des lignes (CSL) de sélection de colonne, des compteurs (32) de consommation de redondance, des mémoires (41, 42) de pile pour des lignes de mot et de lignes de sélection de colonne à réparer, des comparateurs (21, 22) et une unité (CTRL) de commande,
- dans lequel des comparateurs sont reliés aux mémoires de pile pour les lignes de mot à réparer et les lignes de sélection de colonne à réparer et des comparateurs sont reliés à des compteurs d'erreurs pour des lignes (WL) de mot et des lignes (CSL) de sélection de colonne, et
- dans laquelle l'unité (CTRL) de commande est constituée de façon à ce que successivement
a) tout d'abord tous les compteurs d'erreurs et les compteurs de consommation de redondance sont mis à zéro,
b) à l'aide des comparateurs, une comparaison entre une information écrite dans le champ de mémoire et une information lue dans celui-ci est effectuée et une cellule défectueuse est constatée,
c) la ligne de mot et la ligne de sélection de colonne appartenant à la cellule défectueuse est contrôlée pour savoir si elle est déjà mémorisée dans la mémoire de pile et ce n'est alors que si la ligne de mot ou la ligne de sélection de colonne n'a pas encore été mémorisée que le compteur appartenant à la ligne de mot respective et à la ligne de sélection de colonne respective est incrémenté,
d) la ligne de mot et/ou la ligne de sélection de colonne est mémorisée dans la mémoire de pile et le compteur de consommation de redondance associé est incrémenté si les compteurs d'erreurs associés dépassent un seuil de réparation,
e) les stades b) à d) sont effectués pour tous les modèles de test prévus et pour toutes les lignes du champ de commande ou se déroulent jusqu'à ce que l'un des compteurs de consommation de redondance soit débordé,
f) tous les compteurs d'erreurs sont mis à zéro,
g) le stade b) est effectué,
h) le stade c) s'effectue,
i) à l'aide des comparateurs et des compteurs d'erreurs, la ligne de mot et la ligne de sélection de colonne ayant le nombre d'erreurs le plus grand sont déterminées séparément,
j) soit la ligne de mot, soit la ligne de sélection de colonne ayant le nombre d'erreurs le plus grand est sélectionné,
k) cela est mémorisé dans la mémoire de pile et le compteur de consommation de redondance associé est incrémenté dans le cas où le compteur de consommation de redondance associé n'est pas encore débordé,
l) avec l'autre ligne sélectionnée selon le stade i), le stade k) est effectué si, pour la ligne sélectionnée par le stade j), le compteur de consommation de redondance associé est débordé,
m) le test est interrompu si le compteur de consommation de redondance est débordé,
n) les stades f) à m) sont répétés pour tous les modèles de tests prescrits et pour toutes les cellules de mémoire d'un champ de mémoire,
o) le stade n) est répété aussi longtemps que tous les compteurs d'erreurs sont à zéro ou que l'un des compteurs de consommation de redondance est débordé.

2. Mémoire d'écriture/lecture, suivant la revendication 1, dans laquelle il y a moins de compteurs d'erreurs que de lignes de mot et de lignes de sélection de colonne et il y a une mémoire supplémentaire pour un maximum et un nombre d'erreurs associé et les compteurs d'erreurs peuvent être associés par des commutateurs à divers groupes (G) de lignes de mot et de lignes de sélection de colonne, et dans laquelle l'unité de commande est présente de sorte qu'à l'aide des comparateurs, les lignes de mot et les lignes de sélection de colonne ayant le nombre d'erreurs le plus grand dans un groupe sont déterminées et sont mémorisées dans la mémoire de pile au lieu des lignes de mot et de lignes de sélection de colonne ayant le nombre d'erreurs le plus grand jusqu'ici, si le nombre d'erreurs est plus grand que le nombre d'erreurs le plus grand jusqu'ici et en ce que le test est effectué, au lieu de l'être dans toutes les cellules, seulement dans les cellules associées au groupe respectif de lignes de mot et de lignes de sélection de colonne et le test est répété pour tous les groupes du champ de cellule de mémoire.

3. Mémoire d'écriture/lecture, suivant la revendication 1 ou 2, dans laquelle dans le stade j) celle des deux lignes qui est choisie est celle qui a le nombre d'erreurs le plus grand.

4. Mémoire d'écriture/lecture, suivant la revendication 1, dans lequel il y a une mémoire (6) tampon et il y a une unité (CTRL) de commande de façon à ce que d'abord avant les stades a) à g) successivement
A) les cellules défectueuses d'une ligne (WL) de mot sont mémorisées avec la ligne (WL) de mot et la ligne (CSL) de sélection de colonne dans la mémoire tampon,
B) il est vérifié si le nombre d'erreurs dans une ligne de mot dépasse un seuil de réparation prescrit par la dimension de la mémoire tampon et si le seuil de réparation n'est pas dépassé, le contenu de la mémoire tampon est pris en charge dans la mémoire de pile d'erreurs et la mémoire tampon est effacée,
C) une ligne de mot défectueuse est prise en charge dans la mémoire de pile de lignes de mot, la mémoire tampon est effacée et le compteur de consommation de redondance correspondant est incrémenté, si le seuil de réparation a été dépassé, et
D) tandis que la ligne de mot suivante est testée par les stades A) à C), les erreurs de la ligne de mot précédente se trouvant dans la mémoire de pile d'erreurs sont traitées, le compteur (31) d'erreurs prévu pour la ligne de sélection de colonne respective étant incrémenté, et dans le cas où le compteur est débordé, la ligne de sélection de colonne concernée est mémorisée dans la mémoire (42) de pile pour des lignes de sélection de colonne défectueuses et le compteur (32) de consommation de redondance correspondant est incrémenté,
E) les stades A) à D) sont répétés ou interrompus pour tous les modèles de test prévus et pour toutes les cellules du champ de mémoire et sont indiqués déjà comme étant irréparables, si la mémoire de pile d'erreurs ou un compteur de consommation de redondance est débordé.

5. Mémoire d'écriture/lecture comprenant au moins un champ (1) de mémoire et un dispositif d'auto-test,
- dans lequel le dispositif d'auto-test est intégré monolithiquement ensemble avec le au moins un champ de mémoire et a des compteurs (31) d'erreur pour des lignes (WL) de mot et pour des lignes (CSL) de sélection de colonne, des compteurs (32) de consommation de redondance, des mémoires (41, 42) de pile pour des lignes de mot et de lignes de sélection de colonne à réparer, des comparateurs (21, 22) et une unité (CTRL) de commande,
- dans laquelle des comparateurs sont reliés aux mémoires de pile pour les lignes de mot et les lignes de sélection de colonnes à réparer et des comparateurs sont reliés à des compteurs d'erreurs pour des lignes (WL) de mot et des lignes (CSL) de sélection de colonne, et
- dans laquelle les compteurs (31) d'erreurs ayant des largeurs de mot différentes ne sont présents que pour une ligne (WL) de mot et une ligne (CSL) de sélection de commande en plus d'une mémoire (43) de pile pour des erreurs de bit individuel et d'une mémoire (5) de pile d'erreurs et l'unité (CTRL) de commande est constituée de façon que successivement:
a) tout d'abord tous les compteurs d'erreurs et les compteurs de consommation de redondance sont mis à zéro,
b) à l'aide des comparateurs, une comparaison est effectuée entre les informations écrites dans le champ de mémoire et les informations lues dans le champ de mémoire et la cellule défectueuse est déterminée et est mémorisée dans la mémoire de pile d'erreurs,
c) la ligne (WL) de mot appartenant à la cellule défectueuse ainsi que la ligne (CSL) de sélection de colonne sont vérifiées à l'aide de l'un des comparateurs pour savoir si elle a été mémorisée dans la mémoire de pile comme ligne de mot défectueuse, comme ligne de sélection de colonne défectueuse ou comme erreur de bit individuel et les stades d) et e) sont passés si la ligne de mot et/ou la ligne de sélection de colonne ou l'erreur individuelle sont déjà mémorisées,
d) des lignes de mot et des lignes de sélection de colonne mémorisées dans la mémoire de pile d'erreurs associées à la cellule (Z) de mémoire défectueuse sont vérifiées séparément pour savoir s'il y a d'autres erreurs et le compteur d'erreurs associé à la ligne de mot ou le compteur d'erreurs associé à la ligne de sélection de colonne ne sont incrémentées qui si l'erreur supplémentaire n'est pas encore mémorisée dans une mémoire de pile,
e) des lignes de mot et/ou des lignes de sélection de colonne sont mémorisées dans la mémoire de pile correspondante et les compteurs de consommation de redondance associés sont incrémentés si le compteur d'erreurs associé dépasse un seuil de réparation,
f) tous les compteurs d'erreurs sont mis à zéro et les stades b) à e) sont répétés pour tous les modèles de test et toutes les cellules de mémoire du champ de mémoire, et
g) les seuils de réparation s'abaissent par un compteur d'erreur ayant une largeur plus petite de mot et le stade f) est répété jusqu'à ce que, pour le seuil de réparation le plus petit, les compteurs d'erreurs restent pour tous les modèles de test et toutes les cellules de mémoire à zéro ou jusqu'à ce que le compteur de redondance soit débordé.

6. Mémoire d'écriture/lecture suivant la revendication 5, dans lequel au stade d) d'autres erreurs dans la ligne (WL) de mot ne sont recherchées que dans la mémoire (42) de pile pour les lignes de sélection à réparer et d'autres erreurs dans la ligne de sélection (CSL) de colonne associée ne sont recherchées que dans la mémoire (41) de pile pour les lignes de mot.

7. Procédé de test d'une mémoire d'écriture/lecture ayant un dispositif d'auto-test,
- dans lequel des lignes (WL) de mot et/ou des lignes (CSL) de sélection de colonne à réparer sont mémorisées et leurs cellules sont exclues pour d'autres recherches,
- dans lequel les lignes de mot et/ou les lignes de sélection de colonne ayant la plupart des cellules de mémoire défectueuses non encore déjà détectées par les lignes de mot et/ou les lignes de sélection de colonne mémorisées sont déterminées et sont étudiées avant les autres lignes de mot et/ou les autres lignes de sélection de colonne,
- dans lequel il est déterminé si le nombre des lignes redondantes suffit encore et si il n'y a déjà plus de cellules défectueuses et,
- dans lequel
a) des compteurs d'erreurs et des compteurs de consommation de redondance sont mis d'abord à zéro,
b) une comparaison entre une information écrite dans le champ de mémoire et une information lue dans celui-ci est effectuée et la cellule défectueuse est constatée et mémorisée,
c) la ligne de mot et la ligne de sélection de colonne appartenant à la cellule défectueuse sont contrôlées pour savoir si elle est déjà mémorisée et le compteur d'erreurs associé à la ligne de mot et ou à la ligne de sélection de colonne respective est incrémenté seulement si la ligne de mot ou la ligne de sélection de colonne n'a pas encore été mémorisée,
d) la ligne de mot et/ou la ligne de sélection de colonne est mémorisée et le compteur de consommation de redondance associé est incrémenté si les compteurs d'erreurs associés dépassent un seuil de réparation,
e) les stades b) et d) ont effectués pour tous les modèles de test prescrits et pour toutes les cellules du champ de mémoire ou jusqu'à ce que la redondance soit épuisée,
f) tous les compteurs d'erreurs sont mis à zéro,
g) le stade b) est effectué,
h) le stade c) s'effectue,
i) à l'aide des comparateurs et des compteurs d'erreurs, la ligne de mot et la ligne de sélection de colonne ayant le nombre d'erreurs le plus grand sont déterminées séparément,
j) soit la ligne de mot, soit la ligne de sélection de colonne ayant le nombre d'erreurs le plus grand est sélectionnée,
k) celle-ci est mémorisée et le compteur de consommation de redondance est incrémenté dans le cas où on a encore besoin de redondance,
l) il est effectué avec l'autre des lignes sélectionnées suivant le stade i), le stade k) si, pour la ligne sélectionnée suivant le stade j), il n'y a plus de redondance,
m) le test est interrompu si la redondance correspondante est épuisée,
n) les stades f) à m) sont répétés pour tous les modèles de test prescrit et pour toutes les cellules de mémoire du champ de mémoire et le stade n) est répété jusqu'à qu'il n'y ait plus d'erreurs ou jusqu'à ce que la redondance soit épuisée.

8. Procédé de test d'une mémoire d'écriture/lecture comprenant au moins un champ (1) de mémoire et un dispositif d'auto-test,
- dans lequel le dispositif d'auto-test est intégré monolithiquement ensemble avec le au moins un champ de mémoire et a des compteurs (31) d'erreur pour des lignes (WL) de mot et pour des lignes (CSL) de sélection de colonne, des compteurs (32) de consommation de redondance, des mémoires (41, 42) de pile pour des lignes de mot et de lignes de sélection de colonne à réparer, des comparateurs (21, 22) et une unité (CTRL) de commande,
- dans lequel les lignes de mot et/ou les lignes de sélection de colonne ayant la plupart des cellules de mémoire défectueuses non encore déjà détectées par les lignes de mot et/ou les lignes de sélection de colonne mémorisées sont déterminées et sont étudiées avant les autres lignes de mot et/ou les autres lignes de sélection de colonne,
- dans lequel il est déterminé si le nombre des lignes redondantes suffit encore et s'il n'y a déjà plus de cellules défectueuses et,
- dans lequel
a) d'abord tous les compteurs d'erreurs et tous les compteurs de consommation de redondance sont mis à zéro,
b) une comparaison entre les informations écrites dans le champ de mémoire et les informations lues dans le champ de mémoire est effectuée et les cellules défectueuses sont constatées et mémorisées,
c) la ligne (WL) de mot appartenant à la cellule défectueuse ainsi que la ligne (CSL) de sélection de mémoire appartenant à la cellule défectueuse sont contrôlées pour savoir si elle a déjà été mémorisée comme ligne de mot défectueuse, comme ligne de sélection de colonne défectueuse ou comme erreur de bit individuel et les stades d) et e) sont passés si elle a déjà été mémorisée,
d) les lignes de mot et les lignes de sélection de colonne mémorisées intermédiairement et associées à la cellule (Z) de mémoire défectueuse sont vérifiées séparément pour savoir s'il y a des erreurs et le compteur d'erreurs associé à la ligne de mot ou le compteur d'erreur associé à la ligne de sélection de colonne ne sont incrémentées que si l'erreur respective n'est pas encore mémorisée,
e) des lignes de mot et/ou des lignes de sélection de colonne sont mémorisées et les compteurs de consommation de redondance correspondant sont incrémentés si le compteur d'erreurs associé dépasse un seuil de réparation, et
f) tout d'abord tous les compteurs d'erreurs sont mis à zéro et les stades b) à e) sont répétés pour tous les modèles de test et pour toutes les cellules de mémoire du champ de mémoire, et
g) les seuils de réparation sont abaissés et le stade f) est répété jusqu'à ce que, pour le seuil de réparation le plus bas, il ne se produise plus d'erreur pour tous les modèles de test et pour toutes les cellules de mémoire d'erreurs ou jusqu'à ce que l'un des compteurs de consommation de redondance soit débordé.

9. Procédé de test d'une mémoire d'écriture/lecture, suivant la revendication 8, dans lequel tout d'abord avant les stades a) à g) successivement
A) les cellules défectueuses d'une ligne (WL) de mot ayant une ligne (WL) de mot et une ligne (CSL) de sélection de colonne sont mémorisées dans une mémoire tampon,
B) il est vérifié si le nombre d'erreurs dans une ligne de mot dépasse un seuil de réparation et, lorsque le seuil de réparation n'est pas dépassé, le contenu de la mémoire tampon est prise en charge dans une mémoire de pile d'erreurs et la mémoire d'erreurs est effacée,
C) une ligne de mot défectueuse est mémorisée, le tampon est effacé et le compteur de consommation de redondance correspondant est incrémenté si le seuil de réparation a été dépassé, et
D) pendant que la ligne de mot suivante est testée par les stades A) et C), les erreurs de la ligne de mot précédente, se trouvant dans la mémoire de pile d'erreurs, sont traitées, le compteur (31) d'erreurs prévu pour la ligne de sélection de colonne respective étant incrémenté et, si un seuil de réparation est dépassé, la ligne de sélection de colonne concernée est mémorisée et le compteur (32) de consommation de redondance correspondant est incrémenté,
les stades A) à D) sont répétés ou interrompus pour tous les modèles de test prescrits et toutes les cellules du champ de mémoire et sont indiqués déjà comme non réparables si la mémoire de pile d'erreurs ou l'un des compteurs de redondance est débordé.
